# EUROPEAN PATENT SPECIFICATION

(11) **EP 4 163 647 B1**
(45) Date of publication and mention of the grant of the patent: **30.07.2025**
(21) Application number: 22159594.5
(22) Date of filing: 02.03.2022
(51) Int. Cl.: G01R 29/08, H04B 1/40

(54) **5G MILLIMETER WAVE BAND OTA MEASUREMENT SYSTEM**
5G-MILLIMETERWELLEN-OTA-MESSSYSTEM
SYSTÈME DE MESURE OTA DE BANDE D'ONDES MILLIMÉTRIQUES 5G

(30) Priority: 06.10.2021 KR 20210132377
(43) Date of publication of application: 12.04.2023
(73) Proprietor: Korea Testing Laboratory, Gyeongsangnam-do 52852 (KR)
(72) Inventor: SONG, Hoon Geun, 08211 Seoul (KR); KANG, Bong Gyu, 03429 Seoul (KR); LEE, Jaesuk, Suwon-si, Gyeonggi-do 16545 (KR)
(74) Representative: Krauns, Christian

(56) References cited:
- EP-A1- 3 771 112
- CN-B- 109 787 646
- US-A1- 2014 219 142
- JALILI FERIDOON ET AL: "Linearization Trade-Offs in a 5G mmWave Active Phased Array OTA Setup", IEEE ACCESS, IEEE, USA, vol. 8, 13 June 2020 (2020-06-13), pages 110669 - 110677, XP011795311, DOI: 10.1109/ACCESS.2020.3002348

## Description

### BACKGROUND OF THE INVENTION

### Field of the Invention

The present disclosure relates to a 5G millimeter wave band OTA measurement system. More particularly, the present disclosure relates to a 5G millimeter wave band OTA measurement system configured to supply a LO signal required for a frequency converter by compensating for a local signal source loss due to a distance between the frequency converter and devices of a signal analyzer and a signal generator in order to conduct an Over-the-Air (OTA) test for a signal frequency.

### Description of the Related Art

Measurement of signal characteristics of a millimeter wave band used for 5G, such as channel power and error vector magnitude (EVM), is performed by connecting a wideband signal analyzer for signals of several tens of GHz to a millimeter wave band frequency down converter. The millimeter wave band frequency down converter has a structure in which a local signal source required for frequency up/down conversion is supplied through a local signal output of a signal generator or a separate signal generator. In addition, a distance between the local signal sources and the millimeter wave band frequency down converter should be reduced in order to conduct the Over-the-Air (OTA) test using chambers, jigs, and antennas. In general, a local oscillator (LO) signal required for the millimeter wave band frequency up/down converter is supplied through a LO output of the signal analyzer or the LO signal generator. However, in a case where the distance between these devices and the millimeter wave band frequency converter should be far apart from each other, there is a difficulty due to loss according to a length of a LO signal path when it is necessary to secure a sufficient distance and space in a test environment in order to supply sufficient electromagnetic power to a LO port input of the millimeter wave band frequency converter.

In addition, since the LO signal supplied by a typical signal analyzer supplies only a constant power value according to a frequency, the loss of the LO path connected from the LO output port of the signal analyzer to the millimeter wave band frequency down converter is different for each frequency, so there is a disadvantage that it is difficult to supply optimal LO power.

Therefore, when the distance between the signal analyzer and the millimeter wave band frequency up/down converter is greater than or equal to a predetermined distance, a separate expensive signal generator (having 1 to 20 GHz frequency range, and +17 dBm or more output level) that may supply the optimal LO signal power is required.

### Documents of Related Art

(Patent Document 1) Japanese Patent No. 4,821,584 (September 16, 2011)

Feridoon Jalili et al. describe the new generation of 5G mobile communications systems using millimeter active phased arrays which have up to hundreds of individual analog transmitter and receiver chains and antennas in the paper entitled "Linearization Trade-Offs in a 5G mmWave Active Phased Array OTA Setup" IEEE ACCESS, IEEE, USA, vol. 8, 13 June 2020, pages 110669 to 110677.

### SUMMARY OF THE INVENTION

An objective of the present disclosure is to provide a 5G millimeter wave band OTA measurement system configured to supply a LO signal required for a frequency converter by compensating for a local signal source loss due to a distance between the frequency converter and devices of a signal analyzer and a signal generator in order to conduct an Over-the-Air (OTA) test of a signal frequency.

The invention is set out in the appended set of claims.

These problem solutions will become more apparent from the following detailed description of the present disclosure based on the accompanying drawings.

Prior to this, the terms or words used in the present specification and claims should not be construed as conventional and dictionary meanings. On the contrary, based on the principle that the inventor can appropriately define the concept of a term in order to describe his or her invention in the best way, it should be interpreted as meaning and concept consistent with the technical idea of the present disclosure.

That is, according to the exemplary embodiment of the present disclosure, in order to conduct the Over-the-Air (OTA) test of signals generated in a first frequency assembly 1 through a Tx antenna and an Rx antenna, the LO signal of the optimized magnitude required for the frequency up converter and the frequency down converter may be stably supplied by compensating for the local signal source loss due to the distance between devices of the signal analyzer and signal generator and the frequency up converter and frequency down converter that deal with 5G millimeter wave band.

### BRIEF DESCRIPTION OF THE DRAWINGS

FIG. 1 is an exemplary view illustrating a 5G millimeter wave band OTA measurement system according to an exemplary embodiment of the present disclosure.
FIG. 2 is a cross-sectional view illustrating components of a local signal source level control device of the 5G millimeter wave band OTA measurement system and a sequence of adjusting a LO signal level required for operations of a frequency converter, according to the exemplary embodiment of the present disclosure.

### DETAILED DESCRIPTION OF THE INVENTION

The specific aspects and specific technical features of the present disclosure will become more apparent from the following detailed description and exemplary embodiments in conjunction with the accompanying drawings. In adding reference numerals to the components of each drawing, it should be noted that the same reference numerals are used to refer to the same components as much as possible even if displayed on different drawings. In addition, in the following description of the exemplary embodiment of the present disclosure, detailed descriptions of related known functions and components incorporated herein will be omitted when it is determined that the subject matter of the present disclosure may be obscured thereby.

Further, when describing the components of the present disclosure, terms such as first, second, A, B, (a) or (b) may be used. Since these terms are provided merely for the purpose of distinguishing the components from each other, they do not limit the nature, sequence, or order of the components. When a component is described as being "connected", "coupled", or "linked" to another component, that component may be directly connected or connected to that other component. However, it should be understood that yet another component between each of the components may be "connected", "coupled", or "linked" to each other.

Hereinafter, the exemplary embodiment of the present disclosure will be described in detail on the basis of the accompanying drawings.

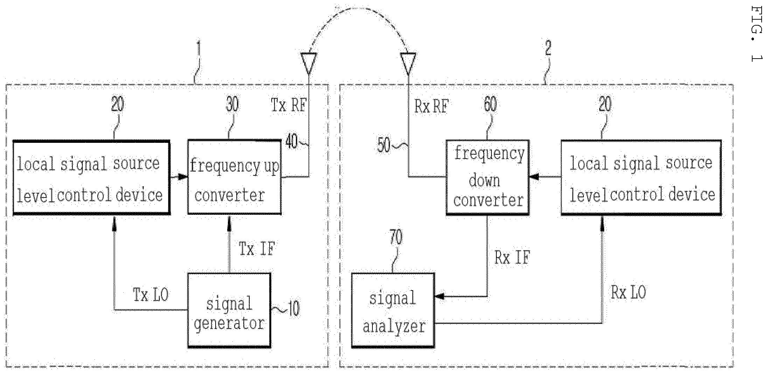

As shown in FIG. 1, the 5G millimeter wave band Over-the-Air (OTA) measurement system according to the exemplary embodiment of the present disclosure may be configured to include: a first frequency assembly 1 configured to generate an intermediate frequency (IF) signal and a LO signal to transmit a signal frequency to outside; and a second frequency assembly 2 configured to receive and analyze the signal frequency transmitted from the first frequency assembly 1.

The first frequency assembly 1 may be configured to include: a signal generator 10 configured to generate a signal frequency; a level control device 20 configured to amplify a Tx LO signal generated by the signal generator and compensate for mismatches; a frequency up converter 30 configured to up-convert the signal frequency by synthesizing a frequency signal; and a Tx antenna 40 configured to transmit the signal frequency to outside.

The signal generator 10 is configured to include: a LO signal generator configured to generate a LO signal; and an IF signal generator configured to generate an IF signal, wherein the Tx LO signal generated by the LO signal generator may be transmitted to the level control device 20 and the IF signal generated by the IF signal generator may be transmitted to the frequency up converter 30.

The level control device 20 performs functions of receiving the Tx LO signal generated by the LO signal generator and amplifying the Tx LO signal to a maximum output, and compensating for mismatches generated when amplifying the Tx LO signal to the maximum output or receiving the signal frequency transmitted from the signal generator 10 to the level control device 20.

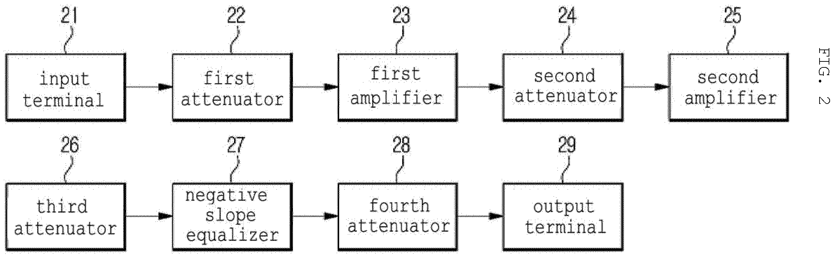

Specifically, as shown in FIG. 2, the level control device 20 may be configured to include: an input terminal 21 configured to receive a Tx LO signal generated by the signal generator 10; attenuators 22, 24, 26, and 28 configured to amplify the signal or compensate for signal mismatches generated when receiving the signal; amplifiers 23 and 25 configured to amplify the signal; a negative slope equalizer 27 configured to compensate, with a negative level attenuation value, for a signal frequency corrected through the amplifiers 23 and 25 and the attenuators 22, 24, 26, and 28; and an output terminal 29 configured to output the signal.

The attenuators 22, 24, 26, and 28 are configured to include a first attenuator 22, a second attenuator 24, a third attenuator 26, and a fourth attenuator 28, and performs functions of receiving the signal and compensating for the previously generated signal mismatch.

The amplifiers 23 and 25 may be configured to include a first amplifier 23 and a second amplifier 25, and may amplify the Tx LO signal with a maximum output of 15 dBm and a gain of 30 dM or more.

A negative slope equalizer performs functions of receiving the signal frequency Tx LO obtained by amplifying the signal and compensating for the signal mismatches by the amplifiers 23 and 25 and the attenuators 22, 24, 26, and 28, and compensating for the received signal frequency with a frequency negative level attenuation value in consideration of a maximum output slope of the second amplifier 25 and a level slope according to a length of a cable connected to the output terminal 29.

In addition, the negative slope equalizer 27 performs functions of adjusting a slope to forcibly be in a reversed direction by applying characteristics of an RF filter, thereby compensating for the slope in a form of gradually decreasing from a low frequency to a high frequency and compensating for a difference in amplification degrees of active devices such as amplifiers depending on the frequencies.

Next, a sequence of amplifying the Tx LO signal and compensating for the mismatches in the level control device 20 so as to adjust an optimal level for the operation of the 5G millimeter wave band frequency is as follows.

First, the level control device 20 may receive a Tx LO signal through the input terminal 21, transmit the received Tx LO signal to the first attenuator 22, and compensate for a signal mismatch generated while transmitting the Tx LO signal from the signal generator 10 to the level control device 20.

The Tx LO signal compensated by the first attenuator 22 may be transmitted to the first amplifier 23 to amplify the Tx LO signal to the maximum output, and the amplified signal may be transmitted to the second attenuator 24.

The second attenuator 24 performs a function of compensating for a signal mismatch generated while amplifying the signal by the first amplifier 23, and transmits the Tx LO signal to the second amplifier 25 after adjusting a signal level according to signal input conditions of the second amplifier 25.

The second amplifier 25 amplifies the signal by outputting the Tx LO signal input from the second attenuator 24 to the value (i.e., the maximum output) output from the first amplifier 23, removes a level change generated in a path of the LO signal source (i.e., cable, etc.), and transmits the Tx LO signal, from which the level change is removed, to the third attenuator 26.

The LO signal source (i.e., Tx LO signal) amplified by the second amplifier 25 may be adjusted to a very stable signal for which an extreme level change is compensated.

The third attenuator 26 performs a function of compensating for a mismatch generated while amplifying the Tx LO signal in the second amplifier 25, and then transmits the Tx LO signal to the negative slope equalizer 27.

The negative slope equalizer performs functions of receiving the Tx LO signal compensated by the third attenuator 26 and compensating for a level slope of a frequency with a frequency negative level attenuation value in consideration of the maximum output slope of the second amplifier 25 and the length of the cable connected to the output terminal 29. Thereafter, the negative slope equalizer transmits the Tx LO signal to the fourth attenuator 28 so as to compensate for a mismatch generated while transmitting the Tx LO signal from the negative slope equalizer 27 to the fourth attenuator 28, and adjusts the Tx LO signal optimized for the 5G millimeter wave band frequency level to transmit to the outside (i.e., frequency up converter) through the output terminal 29.

The frequency up converter 30 receives each of the Tx LO signal adjusted by the level control device 20 and the Tx IF signal generated by the IF signal generator, and performs functions of converting a signal frequency to a Tx RF signal frequency by synthesizing the Tx LO signal and the Tx IF signal and increasing the signal frequency. The Tx RF signal converted by the frequency up converter 30 is transmitted to an external device (i.e., the second frequency assembly 2 in the present disclosure) through the Tx antenna 40.

The second frequency assembly 2 may include: an Rx antenna 50 configured to receive an Rx RF signal from the outside; a level control device 20 configured to receive the Rx LO signal generated by the signal analyzer, amplify the Rx LO signal, and compensate for a mismatch; a frequency down converter 60 configured to down-convert a signal frequency by synthesizing a frequency signal; and a signal analyzer 70 configured to receive an Rx IF signal converted by the frequency down converter 60 and analyze the Rx IF signal.

The signal analyzer 70 is a device that receives the signal frequency converted by the frequency down converter 60 and analyzes the signal, and may be provided with a built-in LO signal generator that generates an Rx LO signal, and may transmit the Rx LO signal to the level control device 20.

The level control device 20 performs functions of receiving the Rx LO signal generated by the LO signal generator to amplify the Rx LO signal to a maximum output, and compensating for a mismatch generated when amplifying the Rx LO signal to the maximum output or a mismatch generated when receiving the signal frequency from the signal generator to the level control device 20.

Specifically, as shown in FIG. 2, the level control device 20 may be configured to include: an input terminal 21 configured to receive a Rx LO signal generated by the signal generator 10; attenuators 22, 24, 26, and 28 configured to amplify a signal or compensate for a signal mismatch generated when receiving the signal; amplifiers 23 and 25 configured to amplify the signal; a negative slope equalizer 27 configured to compensate, with a negative level attenuation value, a signal frequency corrected through the amplifiers 23 and 25 and the attenuators 22, 24, 26, and 28; and an output terminal 29 configured to output the signal.

The attenuators 22, 24, 26, and 28 are configured to include a first attenuator 22, a second attenuator 24, a third attenuator 26, and a fourth attenuator 28, and perform functions of receiving a signal and compensating for the previously generated signal mismatch.

The amplifiers 23 and 25 may be configured to include the first amplifier 23 and the second amplifier 25, and may amplify the Rx LO signal with a maximum output of 15 dBm and a gain of 30 dM or more.

The negative slope equalizer performs functions of receiving a signal frequency Rx LO obtained by amplifying a signal and compensating for a signal mismatch by the amplifiers 23 and 25 and the attenuators 22, 24, 26, and 28, and compensating for a level slope with a frequency negative level attenuation value in consideration of a maximum output slope of the second amplifier 25 and the level slope according to a length of a cable connected to the output terminal 29.

In addition, the negative slope equalizer 27 performs functions of adjusting a slope to forcibly be in a reversed direction by applying characteristics of an RF filter, thereby compensating for the slope in a form of gradually decreasing from a low frequency to a high frequency and compensating for a difference in amplification degrees of active devices such as amplifiers depending on the frequencies.

Next, a sequence of amplifying the Rx LO signal and compensating for the mismatch in the level control device 20 so as to adjust an optimal level for the operation of the 5G millimeter wave band frequency is as follows.

First, the level control device 20 may receive a Rx LO signal through the input terminal 21, transmit the received Rx LO signal to the first attenuator 22, and compensate for a signal mismatch generated while transmitting the Rx LO signal from the signal generator 10 to the level control device 20.

The Rx LO signal compensated by the first attenuator 22 may be transmitted to the first amplifier 23 to amplify the Rx LO signal to the maximum output, and the amplified signal may be transmitted to the second attenuator 24.

The second attenuator 24 performs a function of compensating for a signal mismatch generated while amplifying the signal by the first amplifier 23, and transmits the Rx LO signal to the second amplifier 25 after adjusting a signal level according to signal input conditions of the second amplifier 25.

The second amplifier 25 amplifies the signal by outputting the Rx LO signal input from the second attenuator 24 to the value (i.e., the maximum output) output from the first amplifier 23, removes a level change generated in a path of the LO signal source (i.e., cable, etc.), and transmits the Rx LO signal, from which the level change is removed, to the third attenuator 26.

The LO signal source (i.e., Rx LO signal) amplified by the second amplifier 25 may be adjusted to a very stable signal for which an extreme level change is compensated.

The third attenuator 26 performs a function of compensating for a mismatch generated while amplifying the Rx LO signal in the second amplifier 25, and then transmits the Rx LO signal to the negative slope equalizer 27.

The negative slope equalizer performs functions of receiving the Rx LO signal compensated by the third attenuator 26 and compensating for a level slope of a frequency with a frequency negative level attenuation value in consideration of the maximum output slope of the second amplifier 25 and the length of the cable connected to the output terminal 29. Thereafter, the negative slope equalizer transmits the Rx LO signal to the fourth attenuator 28 so as to compensate for a mismatch generated while transmitting the Rx LO signal from the negative slope equalizer 27 to the fourth attenuator 28, and adjusts the Rx LO signal optimized for the 5G millimeter wave band frequency level to transmit to the outside (i.e., frequency down converter) through the output terminal 29.

That is, the level control device 20 configured in the first frequency assembly 1 and the level control device 20 configured in the second frequency assembly 2 may be configured identically, and their functions in which amplification and attenuation are performed are the same except for a difference in that the level control device 20 configured in the first frequency assembly generates a signal for transmission and the level control device 20 configured in the second frequency assembly generates a signal for reception.

The frequency down converter 60 performs functions of receiving each of the Rx LO signal adjusted by the level control device 20 and the Rx RF signal received from the Rx antenna 50, synthesizing the Rx RF signal and the Rx LO signal (i.e., Rx RF - Rx LO), and then converting the signal frequency to the Rx IF signal by decreasing the signal frequency. The Rx IF signal converted by the frequency down converter 60 may be transmitted to the signal analyzer 70, and the Rx IF signal may be analyzed by the signal analyzer 70.

That is, according to an exemplary embodiment of the present disclosure, in order to conduct the Over-the-Air (OTA) test of the signal generated in the first frequency assembly 1 through a Tx antenna 40 and a Rx antenna 50, the LO signal of the optimized magnitude required for frequency up converter 30 and frequency down converter 60 may be stably supplied by compensating for the local signal source loss due to the distance between devices of the signal analyzer 70 and signal generator 10 and the frequency up converter 30 and frequency down converter 60 that deal with 5G millimeter wave band.

Although the present disclosure has been described in detail through the exemplary embodiment, the exemplary embodiment is for describing the present disclosure in detail, and the 5G millimeter wave band OTA measurement system according to the present disclosure is not limited thereto. In addition, terms such as **"include", "compose", or "have"** described above mean that the corresponding component may be embedded unless otherwise stated, so it should be construed as not excluding other components, but may further include other components. All terms, including technical and scientific terms, have the same meaning as commonly understood by those skilled in the art to which the present disclosure belongs, unless otherwise defined.

Although exemplary aspects of the present disclosure have been described for illustrative purposes, those skilled in the art will appreciate that various modifications, additions and substitutions are possible, without departing from essential characteristics of the present disclosure. Therefore, the exemplary embodiments disclosed in the present disclosure are not intended to limit the technical idea of the present disclosure but to describe the present disclosure, and the scope of the technical idea of the present disclosure is not limited by these exemplary embodiments. The scope of protection of the present disclosure should be interpreted by the following claims.

## Claims

1. A 5G millimeter wave band Over-the-Air, OTA, measurement system, the system comprising:
a signal generator (10) configured to generate a Tx local oscillator, LO, signal and a Tx intermediate frequency, IF, signal;
the system is **characterised by**
a level control device (20) configured to receive the Tx LO signal generated by the signal generator (10), amplify the Tx LO signal to a maximum output, and compensate for mismatches generated when the Tx LO signal is amplified;
a frequency up converter (30) configured to receive each of the Tx IF signal generated by the signal generator (10) and the Tx LO signal amplified and compensated by the level control device (20), and convert a signal frequency to a Tx radio frequency, RF, signal frequency by synthesizing the Tx IF signal and the Tx LO signal and increasing the signal frequency; and
a Tx antenna (40) configured to transmit the Tx RF converted by the frequency up converter (30) to outside.

2. The 5G millimeter wave band OTA measurement system of claim 1, wherein the level control device (20) comprises:
an input terminal (21) configured to receive the Tx LO signal generated by the signal generator (10);
attenuators (22, 24, 26, 28) configured to compensate for the signal mismatches generated while receiving the Tx LO signal through the input terminal (21) or amplifying a signal;
amplifiers (23, 25) configured to amplify the signal received from the input terminal (21) or the attenuators (22, 24, 26, 28); and
an output terminal (29) configured to output the signal to the outside after compensating for the mismatches and amplifying the signal through the attenuators (22, 24, 26, 28) or the amplifiers (23, 25).

3. The 5G millimeter wave band OTA measurement system of claim 2, wherein the level control device (20) comprises:
a first attenuator (22) configured to receive the Tx LO signal through the input terminal (21) and compensate for a mismatch generated while transmitting the Tx LO signal from the signal generator (10) to the level control device (20);
a first amplifier (23) configured to receive the Tx LO signal compensated by the first attenuator (22) and amplify the Tx LO signal up to the maximum output of 15 dBm and a gain of 30 dM or more;
a second attenuator (24) configured to receive the Tx LO signal amplified by the first amplifier (23) and compensate for a mismatch generated while amplifying the signal by the first amplifier (23);
a second amplifier (25) configured to receive the Tx LO signal compensated by the second attenuator (24) and amplify the Tx LO signal to the maximum output in order to remove a level change generated on a path of a signal source;
a third attenuator (26) configured to receive the Tx LO signal amplified by the second amplifier (25) and compensate for a mismatch generated while amplifying the signal in the second amplifier (25);
a negative slope equalizer (27) configured to receive the Tx LO signal compensated by the third attenuator (26) and compensate for a maximum output slope of the second amplifier (25) and a level slope according to a length of a cable connected to the output terminal (29) with a negative level attenuation value of a frequency; and
a fourth attenuator (28) configured to receive the Tx LO signal compensated by the negative slope equalizer (27) and compensate for a mismatch generated while compensating with the negative slope equalizer (27),
wherein the Tx LO signal compensated by the fourth attenuator (28) is transmitted to the output terminal (29).

4. The 5G millimeter wave band OTA measurement system of claim 3, wherein the negative slope equalizer (27) is configured to adjust the level slope of the frequency to be in a reversed direction by applying an RF filter.

5. A 5G millimeter wave band Over-the-Air, OTA, measurement system, the system comprising:
an Rx antenna (50) configured to receive an Rx radio frequency, RF, signal from outside; the system is **characterised by**
a level control device (20) configured to receive a Rx local oscillator, LO, signal generated by a signal analyzer (70), amplify the Rx LO signal to a maximum output, and compensate for mismatches generated when the Rx LO signal is amplified;
a frequency down converter (60) configured to receive each of the Rx RF signal from the Rx antenna (50) and the Rx LO signal amplified and compensated by the level control device (20), and convert a signal frequency to an Rx IF signal frequency by synthesizing the Rx RF signal and the Rx LO signal and decreasing the signal frequency; and
the signal analyzer (70) configured to receive the Rx IF signal converted by the frequency down converter (60) and analyze the Rx IF signal.

6. The 5G millimeter wave band OTA measurement system of claim 5, wherein the level control device (20) comprises:
an input terminal (21) configured to receive the Rx LO signal generated by the signal analyzer (70);
attenuators (22, 24, 26, 28) configured to compensate for the signal mismatches generated while receiving the Rx LO signal through the input terminal (21) or amplifying the signal;
amplifiers (23, 25) configured to amplify the signal received from the input terminal (21) or the attenuators (22, 24, 26, 28); and
an output terminal (29) configured to output the signal to the outside after compensating for the mismatches and amplifying the signal through the attenuators (22, 24, 26, 28) or the amplifiers (23, 25).

7. The 5G millimeter wave band OTA measurement system of claim 6, wherein the level control device (20) comprises:
a first attenuator (22) configured to receive the Rx LO signal through the input terminal (21) and compensate for a mismatch generated while transmitting the Rx LO signal from the signal analyzer (70) to the level control device (20);
a first amplifier (23) configured to receive the Rx LO signal compensated by the first attenuator (22) and amplify the Rx LO signal up to the maximum output of 15 dBm and a gain of 30 dM or more;
a second attenuator (24) configured to receive the Rx LO signal amplified by the first amplifier (23) and compensate for a mismatch generated while amplifying the signal by the first amplifier (23);
a second amplifier (25) configured to receive the Rx LO signal compensated by the second attenuator (24) and amplify the Rx LO signal to the maximum output in order to remove a level change generated on a path of a signal source;
a third attenuator (26) configured to receive the Rx LO signal amplified by the second amplifier (25) and compensate for a mismatch generated while amplifying the signal in the second amplifier (25);
a negative slope equalizer (27) configured to receive the Rx LO signal compensated by the third attenuator (26) and compensate for a maximum output slope of the second amplifier (25) and a level slope according to a length of a cable connected to the output terminal (29) with a negative level attenuation value of a frequency; and
a fourth attenuator (28) configured to receive the Rx LO signal compensated by the negative slope equalizer (27) and compensate for a mismatch generated while compensating with the negative slope equalizer (27),
wherein the Rx LO signal compensated by the fourth attenuator (28) is transmitted to the output terminal (29).

8. The 5G millimeter wave band OTA measurement system of claim 7, wherein the negative slope equalizer (27) is configured to adjust the level slope of the frequency to be in a reversed direction by applying an RF filter.

## Patentansprüche

1. Over-the-Air-Messsystem für ein 5G-Millimeterwellenband, OTA-Messsystem für ein 5G-Millimeterwellenband, wobei das System aufweist:
einen Signalgenerator (10), der ausgestaltet ist, um ein Tx-Lokaloszillatorsignal, Tx-LO-Signal, und ein Tx-Zwischenfrequenzsignal, Tx-IF-Signal, zu erzeugen, wobei das System **gekennzeichnet ist durch**
eine Pegelsteuerungsvorrichtung (20), die ausgestaltet ist, um das von dem Signalgenerator (10) erzeugte Tx-LO-Signal zu empfangen, um das Tx-LO-Signal auf einen maximalen Ausgangspegel zu verstärken und um Fehlanpassungen zu kompensieren, die bei der Verstärkung des Tx-LO-Signals entstehen,
einen Frequenzaufwärtswandler (30), der ausgestaltet ist, um jeweils das von dem Signalgenerator (10) erzeugte Tx-IF-Signal und das von der Pegelregelvorrichtung (20) verstärkte und kompensierte Tx-LO-Signal zu empfangen und um eine Signalfrequenz durch eine Synthetisieren des Tx-IF-Signals und des Tx-LO-Signals und ein Erhöhen der Signalfrequenz in eine Tx-Hochfrequenz-Signalfrequenz, Tx-RF, umzuwandeln, und
eine Tx-Antenne (40), die ausgestaltet ist, um das von dem Frequenzaufwärtswandler (30) umgewandelte Tx-RF nach außen zu senden.

2. OTA-Messsystem für das 5G-Millimeterwellenband nach Anspruch 1, wobei die Pegelsteuerungsvorrichtung (20) aufweist:
einen Eingangsanschluss (21), der ausgestaltet ist, um das von dem Signalgenerator (10) erzeugte Tx-LO-Signal zu empfangen,
Dämpfungsglieder (22, 24, 26, 28), die ausgestaltet sind, um Signalfehlanpassungen zu kompensieren, die beim Empfang des Tx-LO-Signals über den Eingangsanschluss (21) oder beim Verstärken eines Signals entstehen,
Verstärker (23, 25), die ausgestaltet sind, um das von dem Eingangsanschluss (21) oder den Dämpfungsgliedern (22, 24, 26, 28) empfangene Signal zu verstärken, und
einen Ausgangsanschluss (29), der ausgestaltet ist, um das Signal nach Kompensation der Fehlanpassungen und Verstärkung des Signals durch die Dämpfungsglieder (22, 24, 26, 28) oder die Verstärker (23, 25) nach außen auszugeben.

3. OTA-Messsystem für das 5G-Millimeterwellenband nach Anspruch 2, wobei die Pegelsteuerungsvorrichtung (20) aufweist:
ein erstes Dämpfungsglied (22), das ausgestaltet ist, um das Tx-LO-Signal über den Eingangsanschluss (21) zu empfangen und um eine Fehlanpassung zu kompensieren, die während der Übertragung des Tx-LO-Signals von dem Signalgenerator (10) zu der Pegelsteuerungsvorrichtung (20) entsteht,
einen ersten Verstärker (23), der ausgestaltet ist, um das durch das erste Dämpfungsglied (22) kompensierte Tx-LO-Signal zu empfangen und um das Tx-LO-Signal auf die maximale Ausgangsleistung von 15 dBm und eine Verstärkung von 30 dM oder mehr zu verstärken,
ein zweites Dämpfungsglied (24), das ausgestaltet ist, um das durch den ersten Verstärker (23) verstärkte Tx-LO-Signal zu empfangen und um eine während der Verstärkung des Signals durch den ersten Verstärker (23) entstandene Fehlanpassung zu kompensieren,
ein zweiter Verstärker (25), der ausgestaltet ist, um das durch den zweiten Dämpfer (24) kompensierte Tx-LO-Signal zu empfangen und um das Tx-LO-Signal auf die maximale Ausgangsleistung zu verstärken, um eine auf einem Signalquellenpfad erzeugte Pegeländerung zu beseitigen,
ein drittes Dämpfungsglied (26), das ausgestaltet ist, um das durch den zweiten Verstärker (25) verstärkte Tx-LO-Signal zu empfangen und um eine bei der Verstärkung des Signals in dem zweiten Verstärker (25) entstandene Fehlanpassung zu kompensieren,
einen Negativ-Steigungsentzerrer (27), der ausgestaltet ist, um das durch das dritte Dämpfungsglied (26) kompensierte Tx-LO-Signal zu empfangen und um eine maximale Ausgangssteigung des zweiten Verstärkers (25) und eine Pegelsteigung entsprechend einer Länge eines mit dem Ausgangsanschluss (29) verbundenen Kabels mit einem negativen Pegel-Dämpfungswert einer Frequenz zu kompensieren, und
ein viertes Dämpfungsglied (28), das ausgestaltet ist, um das durch den Negativ-Steigungsentzerrer (27) kompensierte Tx-LO-Signal zu empfangen und um eine Fehlanpassung zu kompensieren, die während der Kompensation mit dem Negativ-Steigungsentzerrer (27) entsteht,
wobei das durch das vierte Dämpfungsglied (28) kompensierte Tx-LO-Signal an den Ausgangsanschluss (29) übertragen wird.

4. OTA-Messsystem für das 5G-Millimeterwellenband nach Anspruch 3, wobei der Negativ-Steigungsentzerrer (27) ausgestaltet ist, um die Pegelneigung der Frequenz durch ein Anlegen eines HF-Filters in umgekehrter Richtung einzustellen.

5. OTA-Messsystem für ein 5G-Millimeterwellenband, wobei das System aufweist:
eine Rx-Antenne (50), die ausgestaltet ist, um ein Rx-Hochfrequenzsignal, Rx-HF-Signal, von außen zu empfangen, wobei das System **gekennzeichnet ist durch**
eine Pegelsteuerungsvorrichtung (20), die ausgestaltet ist, um ein Rx-Lokaloszillatorsignal, Rx-LO-Signal, zu empfangen, das von einem Signalanalysator (70) erzeugt wird, um das Rx-LO-Signal auf eine maximale Ausgangsleistung zu verstärken und um Fehlanpassungen zu kompensieren, die bei der Verstärkung des Rx-LO-Signals entstehen, und
einen Frequenzabwärtswandler (60), der ausgestaltet ist, um jeweils das Rx-HF-Signal von der Rx-Antenne (50) und das von der Pegelregelungsvorrichtung (20) verstärkte und kompensierte Rx-LO-Signal zu empfangen und um eine Signalfrequenz durch ein Synthetisieren des Rx-RF-Signals und des Rx-LO-Signals und ein Verringern der Signalfrequenz in eine Rx-IF-Signalfrequenz umzuwandeln,
wobei der Signalanalysator (70) ausgestaltet ist, um das von dem Frequenzabwärtswandler (60) umgewandelte Rx-IF-Signal zu empfangen und das Rx-IF-Signal zu analysieren.

6. OTA-Messsystem für das 5G-Millimeterwellenband nach Anspruch 5, wobei die Pegelsteuervorrichtung (20) aufweist:
einen Eingangsanschluss (21), der ausgestaltet ist, um das von dem Signalanalysator (70) erzeugte Rx-LO-Signal zu empfangen,
Dämpfungsglieder (22, 24, 26, 28), die ausgestaltet sind, um Signalfehlanpassungen zu kompensieren, die beim Empfang des Rx-LO-Signals über den Eingangsanschluss (21) oder beim Verstärken des Signals erzeugt werden,
Verstärker (23, 25), die ausgestaltet sind, um das von dem Eingangsanschluss (21) oder den Dämpfungsgliedern (22, 24, 26, 28) empfangene Signal zu verstärken, und
einen Ausgangsanschluss (29), der ausgestaltet ist, um das Signal nach Kompensation der Fehlanpassungen und Verstärkung des Signals durch die Dämpfungsglieder (22, 24, 26, 28) oder die Verstärker (23, 25) nach außen auszugeben.

7. OTA-Messsystem für das 5G-Millimeterwellenband nach Anspruch 6, wobei die Pegelsteuerungsvorrichtung (20) aufweist:
ein erstes Dämpfungsglied (22), das ausgestaltet ist, um das Rx-LO-Signal über den Eingangsanschluss (21) zu empfangen und um eine Fehlanpassung zu kompensieren, die während der Übertragung des Rx-LO-Signals von dem Signalanalysator (70) zu der Pegelsteuerungsvorrichtung (20) entsteht,
einen ersten Verstärker (23), der ausgestaltet ist, um das durch das erste Dämpfungsglied (22) kompensierte Rx-LO-Signal zu empfangen und um das Rx-LO-Signal auf die maximale Ausgangsleistung von 15 dBm und eine Verstärkung von 30 dM oder mehr zu verstärken,
ein zweites Dämpfungsglied (24), das ausgestaltet ist, um das von dem ersten Verstärker (23) verstärkte Rx-LO-Signal zu empfangen und um eine Fehlanpassung zu kompensieren, die während der Verstärkung des Signals durch den ersten Verstärker (23) entsteht,
einen zweiten Verstärker (25), der ausgestaltet ist, um das durch das zweite Dämpfungsglied (24) kompensierte Rx-LO-Signal zu empfangen und um das Rx-LO-Signal auf die maximale Ausgangsleistung zu verstärken, um eine auf einem Signalquellenpfad erzeugte Pegeländerung zu kompensieren,
ein drittes Dämpfungsglied (26), das ausgestaltet ist, um das durch den zweiten Verstärker (25) verstärkte Rx-LO-Signal zu empfangen und um eine bei der Verstärkung des Signals in dem zweiten Verstärker (25) erzeugte Fehlanpassung zu kompensieren,
einen Negativ-Steigungsentzerrer (27), der ausgestaltet ist, um das durch das dritte Dämpfungsglied (26) kompensierte Rx-LO-Signal zu empfangen und um eine maximale Ausgangssteigung des zweiten Verstärkers (25) und eine Pegelsteigung entsprechend einer Länge eines mit dem Ausgangsanschluss (29) verbundenen Kabels mit einem negativen Pegel-Dämpfungswert einer Frequenz zu kompensieren, und
ein viertes Dämpfungsglied (28), das ausgestaltet ist, um das durch den Negativ-Steigungsentzerrer (27) kompensierte Rx-LO-Signal zu empfangen und um eine Fehlanpassung zu kompensieren, die während der Kompensation mit dem Negativ-Steigungsentzerrer (27) entsteht,
wobei das durch den vierten Dämpfer (28) kompensierte Rx-LO-Signal an den Ausgangsanschluss (29) übertragen wird.

8. OTA-Messsystem für das 5G-Millimeterwellenband nach Anspruch 7, wobei der Negativ-Steigungsentzerrer (27) ausgestaltet ist, um eine Pegelneigung der Frequenz durch ein Anlegen eines HF-Filters in umgekehrter Richtung einzustellen.

## Revendications

1. Système de mesure Over-the-Air, OTA, à bande d'ondes millimétriques 5G, le système comprenant :
un générateur de signal (10) configuré pour générer un signal Tx d'oscillateur local, LO, et un signal Tx de fréquence intermédiaire, IF, ;
le système est **caractérisé par**
un dispositif de commande de niveau (20) configuré pour recevoir le signal Tx LO généré par le générateur de signal (10), amplifier le signal Tx LO à une sortie maximale, et compenser les discordances générées lorsque le signal Tx LO est amplifié ;
un convertisseur élévateur de fréquence (30) configuré pour recevoir chacun du signal Tx IF généré par le générateur de signal (10) et du signal Tx LO amplifié et compensé par le dispositif de commande de niveau (20), et convertir une fréquence de signal en un signal Tx de fréquence radio, RF, en synthétisant le signal Tx IF et le signal Tx LO et en augmentant la fréquence de signal ; et
une antenne Tx (40) configurée pour transmettre vers l'extérieur le signal Tx RF converti par le convertisseur élévateur de fréquence (30).

2. Système de mesure OTA à bande d'ondes millimétriques 5G selon la revendication 1, dans lequel le dispositif de commande de niveau (20) comprend :
une borne d'entrée (21) configurée pour recevoir le signal Tx LO généré par le générateur de signal (10) ;
des atténuateurs (22, 24, 26, 28) configurés pour compenser les discordances de signal générées lors de la réception du signal Tx LO à travers la borne d'entrée (21) ou de l'amplification d'un signal ;
des amplificateurs (23, 25) configurés pour amplifier le signal reçu de la borne d'entrée (21) ou des atténuateurs (22, 24, 26, 28) ; et
une borne de sortie (29) configurée pour émettre le signal vers l'extérieur après avoir compensé les discordances et amplifié le signal à travers les atténuateurs (22, 24, 26, 28) ou les amplificateurs (23, 25).

3. Système de mesure OTA à bande d'ondes millimétriques 5G selon la revendication 2, dans lequel le dispositif de commande de niveau (20) comprend :
un premier atténuateur (22) configuré pour recevoir le signal Tx LO à travers la borne d'entrée (21) et compenser une discordance générée tout en transmettant le signal Tx LO du générateur de signal (10) au dispositif de commande de niveau (20) ;
un premier amplificateur (23) configuré pour recevoir le signal Tx LO compensé par le premier atténuateur (22) et amplifier le signal Tx LO jusqu'à la sortie maximale de 15 dBm et un gain de 30 dM ou plus ;
un deuxième atténuateur (24) configuré pour recevoir le signal Tx LO amplifié par le premier amplificateur (23) et compenser une discordance générée tout en amplifiant le signal par le premier amplificateur (23) ;
un deuxième amplificateur (25) configuré pour recevoir le signal Tx LO compensé par le deuxième atténuateur (24) et amplifier le signal Tx LO à la sortie maximale afin de supprimer un changement de niveau généré sur un chemin d'une source de signal ;
un troisième atténuateur (26) configuré pour recevoir le signal Tx LO amplifié par le deuxième amplificateur (25) et compenser une discordance générée tout en amplifiant le signal dans le deuxième amplificateur (25) ;
un égaliseur de pente négative (27) configuré pour recevoir le signal Tx LO compensé par le troisième atténuateur (26) et compenser une pente de sortie maximale du deuxième amplificateur (25) et une pente de niveau selon une longueur d'un câble connecté à la borne de sortie (29) avec une valeur d'atténuation de niveau négative d'une fréquence ; et
un quatrième atténuateur (28) configuré pour recevoir le signal Tx LO compensé par l'égaliseur de pente négative (27) et compenser une discordance générée tout en compensant avec l'égaliseur de pente négative (27),
dans lequel le signal Tx LO compensé par le quatrième atténuateur (28) est transmis à la borne de sortie (29).

4. Système de mesure OTA à bande d'ondes millimétriques 5G selon la revendication 3, dans lequel l'égaliseur de pente négative (27) est configuré pour ajuster la pente de niveau de la fréquence pour qu'elle soit dans une direction inversée en appliquant un filtre RF.

5. Système de mesure Over-the-Air, OTA, à bande d'ondes millimétriques 5G, le système comprenant :
une antenne Rx (50) configurée pour recevoir un signal Rx de fréquence radio, RF, de l'extérieur ; le système est **caractérisé par**
un dispositif de commande de niveau (20) configuré pour recevoir un signal Rx d'oscillateur local, LO, généré par un analyseur de signal (70), amplifier le signal Rx LO à une sortie maximale, et compenser les discordances générées lorsque le signal Rx LO est amplifié ;
un convertisseur abaisseur de fréquence (60) configuré pour recevoir chacun du signal Rx RF de l'antenne Rx (50) et du signal Rx LO amplifié et compensé par le dispositif de commande de niveau (20), et convertir une fréquence de signal en une fréquence de signal Rx IF en synthétisant le signal Rx RF et le signal Rx LO et en diminuant la fréquence de signal ; et
l'analyseur de signal (70) configuré pour recevoir le signal Rx IF converti par le convertisseur abaisseur de fréquence (60) et analyser le signal Rx IF.

6. Système de mesure OTA à bande d'ondes millimétriques 5G selon la revendication 5, dans lequel le dispositif de commande de niveau (20) comprend :
une borne d'entrée (21) configurée pour recevoir le signal Rx LO généré par l'analyseur de signal (70) ;
des atténuateurs (22, 24, 26, 28) configurés pour compenser les discordances de signal générées lors de la réception du signal Rx LO à travers la borne d'entrée (21) ou de l'amplification du signal ;
des amplificateurs (23, 25) configurés pour amplifier le signal reçu de la borne d'entrée (21) ou des atténuateurs (22, 24, 26, 28) ; et
une borne de sortie (29) configurée pour émettre le signal vers l'extérieur après avoir compensé les discordances et amplifié le signal à travers les atténuateurs (22, 24, 26, 28) ou les amplificateurs (23, 25).

7. Système de mesure OTA à bande d'ondes millimétriques 5G selon la revendication 6, dans lequel le dispositif de commande de niveau (20) comprend :
un premier atténuateur (22) configuré pour recevoir le signal Rx LO à travers la borne d'entrée (21) et compenser une discordance générée tout en transmettant le signal Rx LO de l'analyseur de signal (70) au dispositif de commande de niveau (20) ;
un premier amplificateur (23) configuré pour recevoir le signal Rx LO compensé par le premier atténuateur (22) et amplifier le signal Rx LO jusqu'à la sortie maximale de 15 dBm et un gain de 30 dM ou plus ;
un deuxième atténuateur (24) configuré pour recevoir le signal Rx LO amplifié par le premier amplificateur (23) et compenser une discordance générée tout en amplifiant le signal par le premier amplificateur (23) ;
un deuxième amplificateur (25) configuré pour recevoir le signal Rx LO compensé par le deuxième atténuateur (24) et amplifier le signal Rx LO à la sortie maximale afin de supprimer un changement de niveau généré sur un chemin d'une source de signal ;
un troisième atténuateur (26) configuré pour recevoir le signal Rx LO amplifié par le deuxième amplificateur (25) et compenser une discordance générée tout en amplifiant le signal dans le deuxième amplificateur (25) ;
un égaliseur de pente négative (27) configuré pour recevoir le signal Rx LO compensé par le troisième atténuateur (26) et compenser une pente de sortie maximale du deuxième amplificateur (25) et une pente de niveau selon une longueur d'un câble connecté à la borne de sortie (29) avec une valeur d'atténuation de niveau négative d'une fréquence ; et
un quatrième atténuateur (28) configuré pour recevoir le signal Rx LO compensé par l'égaliseur de pente négative (27) et compenser une discordance générée tout en compensant avec l'égaliseur de pente négative (27),
dans lequel le signal Rx LO compensé par le quatrième atténuateur (28) est transmis à la borne de sortie (29).

8. Système de mesure OTA à bande d'ondes millimétriques 5G selon la revendication 7, dans lequel l'égaliseur de pente négative (27) est configuré pour ajuster la pente de niveau de la fréquence pour qu'elle soit dans une direction inversée en appliquant un filtre RF.
